# EUROPÄISCHE PATENTSCHRIFT

(11) **EP 1 570 315 B1**
(45) Veröffentlichungstag und Bekanntmachung des Hinweises auf die Patenterteilung: **26.12.2007**
(21) Anmeldenummer: 03717185.7
(22) Anmeldetag: 17.02.2003
(51) Int. Cl.: G03F 7/20

(54) **VERFAHREN ZUR EINSTELLUNG EINER GEWÜNSCHTEN OPTISCHEN EIGENSCHAFT EINES PROJEKTIONSOBJEKTIVS SOWIE MIKROLITHOGRAFISCHE PROJEKTIONSBELICHTUNGSANLAGE**
METHOD FOR ADJUSTING AN OPTICAL IMAGING PROPERTY OF A PROJECTION OBJECTIVE OF A MICROLITHOGRAPHIC PROJECTION EXPOSURE APPARATUS
PROCEDE DE REGLAGE D'UNE PROPRIETE OPTIQUE SOUHAITEE D'UN OBJECTIF DE PROJECTION ET INSTALLATION D'ECLAIRAGE DE PROJECTION MICROLITHOGRAPHIQUE

(30) Priorität: 10.12.2002 DE 10257766
(43) Veröffentlichungstag der Anmeldung: 07.09.2005
(73) Patentinhaber: Carl Zeiss SMT AG, 73447 Oberkochen (DE)
(72) Erfinder: GRÄUPNER, Paul, 73430 Aalen (DE)
(74) Vertreter: Schwanhäusser, Gernot
(86) Internationale Anmeldenummer: PCT/EP2003/001564
(87) Internationale Veröffentlichungsnummer: WO 2004/053596

(56) Entgegenhaltungen:
- EP-A- 0 605 103
- EP-A- 0 678 768
- JP-A- 2002 341 249
- US-B1- 6 335 787

## Beschreibung

Die Erfindung betrifft ein Verfahren nach dem Oberbegriff des Anspruchs 1 sowie eine Projektionsbelichtungsanlage nach dem Oberbegriff des Anspruchs 7. Die Erfindung betrifft außerdem eine derartige Projektionsbelichtungsanlage, bei der in den genannten Zwischenraum bereits eine Immersionsflüssigkeit eingebracht ist.

Ein Verfahren der genannten Art ist allgemein im Stand der Technik bekannt. So läßt sich bei zahlreichen Projektionsobjektiven mikrolithografischer Projektionsbelichtungsanlagen die räumliche Lage einzelner optischer Komponenten mit Hilfe von Manipulatoren so verändern, daß sich die Abbildungseigenschaften des Projektionsobjektivs verbessern. Die Lageveränderung der betreffenden optischen Komponenten zur Verbesserung der Abbildungseigenschaften des Projektionsobjektivs erfolgt dabei am fertig montierten Projektionsobjektiv, und zwar in der Regel noch vor dessen erstmaliger Inbetriebnahme. Diese Art der Feinjustierung kann aber auch zu einem späteren Zeitpunkt vorgenommen werden, um beispielsweise alterungsbedingte Verschlechterungen der Abbildungseigenschaften zu kompensieren. Häufig geht man bei diesen Verfahren so vor, daß man eine oder mehrere Abbildungseigenschaften des Projektionsobjektivs mit Hilfe eines in dessen Bildebene angeordneten Sensors erfasst. Sodann beobachtet man, wie sich Lageveränderungen einzelner optischer Komponenten auf die Abbildungseigenschaften auswirken. Durch mehr oder weniger zielgerichtete Justage der optischen Komponenten können auf diese Weise die optischen Abbildungseigenschaften des Projektionsobjektivs optimiert werden.

Eine mikrolithografische Projektionsbelichtungsanlage der eingangs genannten Art ist aus der EP 0 023 231 B1 bekannt. Diese bekannte Projektionsbelichtungsanlage weist zur Aufnahme eines Trägers für eine zu belichtende Halbleiterscheibe einen oben offenen Behälter auf, dessen oberer Rand höher liegt als die untere Begrenzungsfläche des Projektionsobjektivs. Der Behälter ist mit Zu- und Ableitungen für eine Immersionsflüssigkeit versehen, die in einem Flüssigkeitskreislauf umgewälzt wird. Die Immersionsflüssigkeit füllt beim Betrieb der Projektionsbelichtungsanlage den Zwischenraum aus, der zwischen der zu belichtenden Halbleiterscheibe und einer dieser zugewandten Grenzfläche des Projektionsobjektivs verbleibt. Durch den höheren Brechungsindex der Immersionsflüssigkeit im Vergleich zu Luft wird das Auflösungsvermögen des Projektionsobjektivs vergrößert.

Die bekannte Projektionsbelichtungsanlage weist ferner eine in dem Flüssigkeitskreislauf angeordnete Einrichtung zur Temperierung der Immersionsflüssigkeit auf. Auf diese Weise läßt sich die Temperatur der zu belichtenden Halbleiterscheibe konstant halten, so daß durch Wärmebewegungen der Halbleiterscheibe hervorgerufene Abbildungsfehler zu vermieden werden.

Die Verwendung von Immersionsflüssigkeiten bei mikrolithografischen Projektionsbelichtungsanlagen ist auch aus der JP 10-303 114 A bekannt. Dort wird auf das Problem hingewiesen, daß unerwünschte Temperaturschwankungen der Immersionsflüssigkeit auch zu einer Verschlechterung der Abbildungseigenschaften des Projektionsobjektivs führen können. Die Ursache hierfür liegt in der Abhängigkeit des Brechungsindex der Immersionsflüssigkeit von der Temperatur. Zur Lösung dieses Problems werden verschiedene Maßnahmen vorgeschlagen, mit denen sich die Temperatur der Immersionsflüssigkeit während des Betriebs der Projektionsbelichtungsanlage in engen Grenzen konstant halten läßt.

Aus der EP 0 605 103 A1 ist eine Projektionsbelichtungsanlage bekannt, bei welcher das zu belichtende Substrat in einer flüssigkeitsgefüllten Kassette aufgenommen ist, die zum Projektionsobjektiv hin durch eine plan-parallele transparente Platte begrenzt ist. Bei der Befüllung der Kassette mit einer Immersionsflüssigkeit wird die Temperatur der Flüssigkeit mit Hilfe eines Thermometers erfaßt. Weicht die gemessene Temperatur von einer vorgegebenen Temperatur ab, so wird die Kassette mit weiterer temperierter Immersionsflüssigkeit durchspült.

Aus der EP 0 678 768 A2 ist eine Projektionsbelichtungsanlage bekannt, bei der Linsen durch das Projektionslicht in nicht rotationssymmetrischer Weise erwärmt werden. Dadurch kann es beispielsweise zu einer Veränderung der Brennweite des Projektionsobjektivs kommen.

Aus der JP 2002-341249 ist ein Mikroskop mit einem Immersionsobjektiv bekannt, bei dem sich Linsen oder Linsengruppen entlang der optischen Achse verfahren lassen. Auf diese Weise ist eine Korrektur von sphärischen Aberrationen möglich, die durch Temperaturschwankungen der Immersionsflüssigkeit hervorgerufen werden.

Aufgabe der vorliegenden Erfindung ist es, ein Verfahren sowie eine mikrolithografische Projektionsbelichtunsanlage der eingangs genannten Art anzugeben, bei dem sich die optischen Abbildungseigenschaften eines fertig montierten Projektionsobjektivs noch leichter und wirkungsvoller verbessern lassen.

Bei einem Verfahren der eingangs genannten Art wird diese Aufgabe durch folgende Schritte gelöst:
a) Ermitteln einer Abbildungseigenschaft der Projektionsobjektivs;
b) Vergleichen der ermittelten Abbildungseigenschaft mit einer Soll-Abbildungseigenschaft;
c) Verändern der Temperatur der Immersionsflüssigkeit so lange, bis die ermittelte Abbildungseigenschaft der Soll-Abbildungseigenschaft möglichst nahe kommt.

Zur Verbesserung der optischen Abbildungseigenschaften des Projektionsobjektivs wird die Erkenntnis genutzt, daß die Immersionsflüssigkeit eine optische Komponente der Projektionsbelichtungsanlage darstellt, die deren optische Eigenschaften im Prinzip genau so beeinflusst wie etwa die im Projektionsobjektiv angeordneten Linsen. Anstatt nun (ausschließlich) die Linsen oder andere optische Komponenten im Projektionsobjektiv mechanisch im Strahlengang des Projektionsobjektivs zu justieren, nutzt die Erfindung die Möglichkeit, den Brechungsindex der optischen Komponente "Immersionsflüssigkeit" über deren Temperatur zu beeinflussen.

Zwar läßt sich im Prinzip auch der Brechungsindex der im Projektionsobjektiv enthaltenden optischen Komponenten über die Temperatur verändern, doch ist dort eine Temperaturveränderung ungleich schwerer herbeizuführen, da die für die Linsen u. ä. verwendeten Materialien eine geringe Wärmeleitfähigkeit besitzen, wodurch die Einstellung einer homogenen Temperaturverteilung über das gesamte optisch wirksame Volumen hinweg erheblich erschwert wird. Die Temperatur der Immersionsflüssigkeit läßt sich hingegen relativ einfach auf einen vorgebbaren Wert bringen und über den entsprechenden optisch wirksamen Bereich hinweg konstant halten, z. B. indem die Flüssigkeit umgewälzt wird.

Da der Brechungsindex zahlreicher als Immersionsflüssigkeit geeigneter Flüssigkeiten nur recht schwach und - innerhalb kleiner Temperaturintervalle - annähernd linear von der Temperatur abhängt, läßt sich der Brechungsindex der Immersionsflüssigkeit sehr präzise über die Temperatur einstellen. So läßt sich beispielsweise bei einer für eine Wellenlänge von 193 nm ausgelegten Projektionsbelichtungsanlage, bei der der Zwischenraum zwischen der lichtempfindlichen Oberfläche und der Endfläche des Projektionsobjektivs mit einer 1 mm dicken Wasserschicht aufgefüllt ist, der Brechungsindex von n = 1,45 um ein hundertstel Promill verändern, indem die Temperatur um 50 mK erhöht oder erniedrigt wird.

Theoretisch ist es möglich, zur Ermittlung der Abbildungseigenschaft ein zusätzliches optisches System derart in der Bildebene des Projektionsobjektivs zu positionieren, daß ein von dem Projektionsobjektiv erzeugtes Bild unmittelbar auf einem Schirm oder durch ein Okular hindurch beobachtet werden kann. Vorzugsweise jedoch wird die Abbildungseigenschaft ermittelt, indem ein Testretikel durch das Projektionsobjektiv und die Immersionsflüssigkeit hindurch auf ein in der Bildebene angeordnetes lichtempfindliches Element abgebildet wird. Die Abbildungseigenschaften lassen sich dann reproduzierbar und quantifizierbar ermitteln, indem das auf dem lichtempfindlichen Element gespeicherte Bild mit an sich bekannten Vorrichtungen vermessen wird. Als lichtempfindliches Element kommt bei spielsweise eine Fotoemulsion in Betracht.

Besonders bevorzugt ist es jedoch, wenn das lichtempfindliche Element eine Sensoreinrichtung, insbesondere ein CCD-Sensor, ist. Auf diese Weise kann das in der Bildebene erzeugte Bild unmittelbar, d. h. ohne Entwicklung einer Fotoemulsion o. ä., erfasst und ausgewertet werden, um die Abbildungseigenschaften zu ermitteln.

Alternativ hierzu kann die Abbildungseigenschaft auch unter Verwendung eines Interferometers ermittelt werden, wie es beispielsweise aus der WO 01/632 33 A1 bekannt ist.

Mit Hilfe des erfindungsgemäßen Verfahrens lassen sich alle optischen Abbildungseigenschaften des Projektionsobjektivs verbessern, die durch die Immersionsflüssigkeit beeinflußbar sind. So kann es sich beispielsweise bei der zu verbessernden optischen Abbildungseigenschaft um eine durch das Projektionsobjektiv verursachte sphärische Aberration handeln. Derartige sphärische Aberrationen treten insbesondere bei Projektionsobjektiven mit hoher numerischer Apertur auf.

Bei der zu verbessernden optischen Eigenschaft kann es sich aber beispielsweise auch um die Brennweite des Projektionsobjektivs handeln. Da zur hochauflösenden Abbildung der in dem Retikel enthaltenen abzubildenden Strukturen auf der lichtempfindlichen Oberfläche letzere sehr genau in der Brennebene des Projektionsobjektivs angeordnet sein muß, weisen herkömmliche Projektionsbelichtungsanlagen häufig eine Verstellmöglichkeit auf, mit der der Träger der lichtempfindlichen Oberfläche entlang der optischen Achse des Projektionsobjektivs bewegt werden kann. Auf diese Weise läßt sich die lichtempfindliche Oberfläche in die Brennebene des Projektionsobjektivs justieren. Diese mechanischen Verstelleinrichtungen sind allerdings konstruktiv relativ aufwendig. Durch Verändern der Temperatur der Immersionsflüssigkeit läßt sich erfindungsgemäß auf sehr einfache Weise die Brennweite des Projektionsobjektivs beeinflussen, so daß auf eine Verstellmöglichkeit für den Träger der lichtempfindlichen Oberfläche verzichtet werden kann.

Bei einer Projektionsbelichtungsanlage der eingangs genannten Art wird die oben genannte Aufgabe gelöst durch eine in der Bildebene anordenbare Sensoreinrichtung zur Erfassung einer Abbildungseigenschaft des Projektionsobjektivs und einer mit der Sensoreinrichtung und der Temperaturregelungseinrichtung verbundenen Recheneinheit, mit der aus von der Sensoreinrichtung erzeugten Signalen die Soll-Temperatur der Immersionsflüssigkeit so bestimmbar ist, daß sich die Abbildungseigenschaft des Projektionsobjektivs bei Einstellen der Soll-Temperatur verbessert.

Eine derartige Projektionsbelichtungsanlage erlaubt eine automatisierte Verbesserung der optischen Abbildungseigenschaften des Projektionsobjektivs durch Verändern der Temperatur der Immersionsflüssigkeit. Die Recheneinheit kann dabei z. B. so ausgelegt werden, daß sie aus den von der Sensoreinrichtung erzeugten Signalen die Abbildungseingenschaften des Projektionsobjektivs ermittelt und mit einer Soll-Abbildungseigenschaft vergleicht. In einem Regelvorgang veranlasst dann die Recheneinheit die Temperatursteuerungseinrichtung, die Temperatur der Immersionsflüssigkeit so lange zu verändern, bis die von der Sensoreinrichtung erfasste Abbildungseigenschaft der Soll-Abbildungseigenschaft möglichst nahekommt. Eine derartige Projektionsbelichtungsanlage ermöglicht es einem Betreiber, bestimmte Verschlechterungen der Abbildungseigenschaften des Projektionsobjektivs automatisch, d. h. ohne Hinzuziehung von Spezialisten, durch eine Veränderung des Brechungsindex der Immersionsflüssigkeit zu kompensieren. Als Ursache für die Verschlechterungen kommen z. B. alterungsbedingte Materialveränderungen oder Schwankungen des Luftdrucks in Betracht.

Gegenstand der Erfindung ist ferner eine Projektionsbelichtungsanlage mit einer Immersionsflüssigkeit, deren Temperatur so gewählt ist, daß durch die Immersionsflüssigkeit eine dem Projektionsobjektiv eigene sphärische Aberration kompensiert ist.

Weitere Vorteile und Merkmale der Erfindung ergeben sich aus der nachfolgenden Beschreibung eines Ausführungsbeispiels anhand der Zeichnungen. Darin zeigen:
- Figur 1: eine vereinfachte Darstellung einer mikrolithografischen Projektionsbelichtungsanlage in einem Längsschnitt;
- Figur 2: einen vergrößerten Ausschnitt aus Figur 1, in dem ein Strahlengang im Bereich einer Immersionsflüssigkeit angedeutet ist;
- Figur 3: den Ausschnitt gemäß Figur 2, jedoch nach Erhöhung der Temperatur der Immersionsflüssigkeit;
- Figur 4: einen der Figur 2 entsprechenden vergrößerten Ausschnitt aus einer Projektionsbelichtungsanlage mit einer anderen Abbildungsoptik;
- Figur 5: den Ausschnitt gemäß Figur 4, jedoch nach Erhöhung der Temperatur der Immersionsflüssigkeit;
- Figur 6: eine vereinfachte Darstellung einer anderen mikrolithografischen Projektionsbelichtungsanlage mit einer in der Bildebene angeordneten Sensoreinrichtung in einem Längsschnitt.

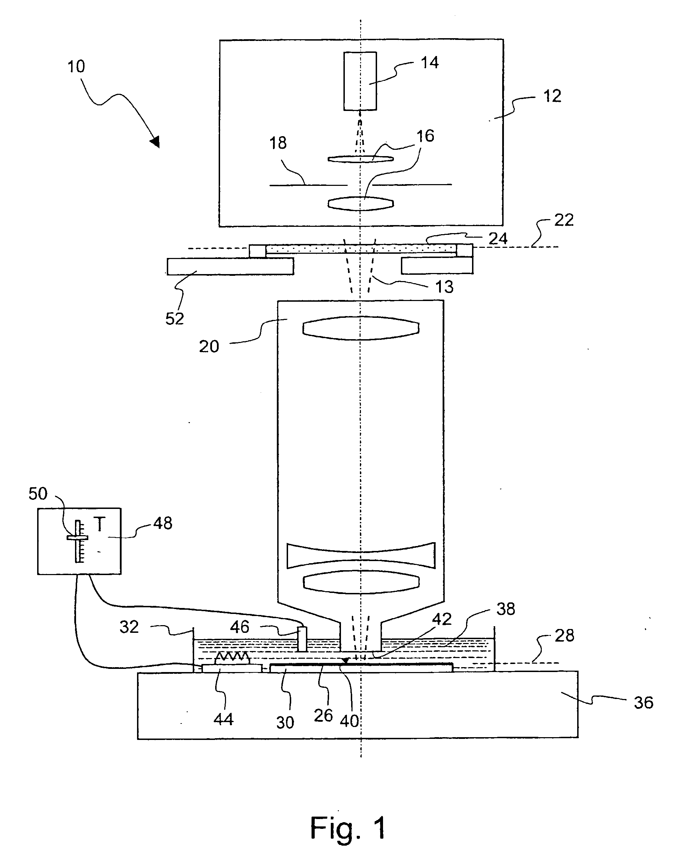

Figur 1 zeigt eine insgesamt mit 10 bezeichnete mikrolithografische Projektionsbelichtungsanlage in einem Längsschnitt. Die Projektionsbelichtungsanlage 10 weist eine Beleuchtungseinrichtung 12 zur Erzeugung eines Projektionslichtbündels 13 auf, die eine Projektionslichtquelle 14, eine mit 16 angedeutete Beleuchtungsoptik und eine Blende 18 umfasst.

Die Projektionsbelichtungsanlage 10 hat ferner ein Projektionsobjektiv 20, das ein in seiner Objektebene 22 angeordnetes Retikel 24 verkleinert auf eine lichtempfindliche Oberfläche 26 abbildet, die in einer Bildebene 28 des Projektionsobjektivs 20 angeordnet ist. Das Projektionsobjektiv 20 enthält eine Vielzahl optischer Komponenten, von denen in Figur 1 nur einige beispielhaft dargestellt und nicht näher bezeichnet sind.

Bei der lichtempfindlichen Oberfläche 26 kann es sich beispielsweise um einen Fotolack handeln, der auf einem Träger 30, z. B. einem Siliziumwafer, aufgebracht ist. Der Träger 30 ist am Boden eines wannenartigen, nach oben offenen Behälters 32 befestigt, der durch eine mit 36 bezeichnete erste Verfahreinrichtung parallel zur Bildebene verfahrbar ist. Der Behälter 32 ist mit einer Immersionsflüssigkeit 38 soweit aufgefüllt, daß ein Zwischenraum 40 zwischen der lichtempfindlichen Oberfläche 26 und einer dieser Oberfläche 26 zugewandten Endfläche 42 des Projektionsobjektivs 20 vollständig mit der Immersionsflüssigkeit 38 gefüllt ist.

In dem Behälter 32 ist außerdem eine Temperiereinrichtung 44 vorgesehen, die als reine Heizeinrichtung, aber auch als kombinierte Heiz-/Kühleinrichtung ausgeführt sein kann. Außerdem ist an dem Behälter 32 ein Temperaturfühler 46 befestigt, der die Temperatur der Immersionsflüssigkeit 38 mit hoher Genauigkeit erfasst.

Die Temperiereinrichtung 44 und der Temperaturfühler 46 sind über die Verfahrbewegung des Behälters 32 nicht behindernde Leitungen mit einem Temperaturregler 48 verbunden, der einen Schiebeschalter 50 zur Einstellung einer Führungstemperatur aufweist.

Das Retikel 24, dessen Strukturen auf der lichtempfindlichen Oberfläche 26 abgebildet werden sollen, ist mit Hilfe einer zweiten Verfahreinrichtung 52 in der Objektebene 22 verfahrbar, so daß nach und nach sämtliche strukturierten Bereiche des Retikels 24 auf der lichtempfindlichen Oberfläche 26 abgebildet werden können.

Die Projektionsbelichtungsanlage 10 funktioniert auf folgende Weise :

Das von der Beleuchtungseinrichtung 12 erzeugte Projektionslichtbündel 13 durchtritt die Strukturen des Retikels 24 und gelangt von dort in das Projektionsobjektiv 20. Durch dieses werden die Strukturen, die von dem Projektionslichtbündel 13 durchtreten werden, verkleinert auf der lichtempfindlichen Oberfläche 26 abgebildet. Um die gesamte Fläche des Retikels 24 auf der lichtempfindlichen Oberfläche 26 abzubilden, kann das Retikel 24 in einem "step and scan"-Vorgang beleuchtet werden. Dabei wird der Gesamtbereich des Retikels 24 scannend beleuchtet, indem das Retikel 24 mit Hilfe der zweiten Verfahreinrichtung 52 durch das von der Blende 18 begrenzte Projektionslichtbündel hindurch bewegt wird. Der Behälter 32 mit dem darin befestigten Träger 30 führt während dieser Scanbewegung eine (meist gegenläufige) Bewegung mit Hilfe der ersten Verfahreinrichtung 36 aus, dessen Verfahrgeschwindigkeit gegenüber derjenigen des Retikels 24 um das Verkleinerungsverhältnis des Projektionsobjektivs 20 herabgesetzt ist.

Bei dieser Verfahrbewegung des Behälters 32 wird die Endfläche 42 des Projektionsobjektivs 20 durch die vom Behälter 32 mitgeführte Immersionsflüssigkeit 38 bewegt, was zu einer Durchmischung der Immersionsflüssigkeit 38 führt. Eine solche Durchmischung ist insofern erwünscht, als sich die Immersionsflüssigkeit 38 aufgrund des durchtretenden Projektionslichts lokal erwärmen kann, so daß der Temperaturfühler 46 ansonsten möglicherweise nicht mehr die tatsächlich in dem Zwischenraum 40 gegebene Temperatur erfassn würde. Falls die Durchmischung aufgrund der Verfahrbewegung des Behälters 32 nicht ausreichen sollte, können selbstverständlich zusätzliche Mischeinrichtungen im Behälter 32 angeordnet sein. Ebenso ist es möglich, den Behälter 32 in einen Flüssigkeitskreislauf einzufügen, wie dies im Stand der Technik an sich bekannt ist. Die Temperiereinrichtung 44 sowie der Temperaturfühler 46 können dann neben einem ggfs. vorhandener Filter in diesen Temperaturkreislauf integriert sein.

Falls in einem Testvorgang bei der Justage des Projektionsobjektivs oder im späteren Betrieb durch Prüfung der hergestellten Wafer festgestellt wird, daß die Abbildungseigenschaft des Projektionsobjektivs 20 nicht einer gewünschten Soll-Abbildungseigenschaft entspricht, z. B. weil die Abbildung auf der lichtempfindlichen Oberfläche 26 durch sphärische Aberration verfälscht ist, so wird durch Betätigung des Schiebeschalters 50 die Führungstemperatur des Temperaturreglers 48 verändert und die Belichtung wiederholt. Durch Verändern der Temperatur der Immersionsflüssigkeit 38 verändert sich deren Brechungsindex. Die Abhängigkeit des Brechungsindex von der Temperatur ist - zumindest in kleinen Temperaturintervallen - bei vielen Immersionsflüssigkeiten 38 annähernd linear, so daß sich auf recht einfache Weise in einem rekursiven Prozess eine Temperatur für die Immersionsflüssigkeit 38 ermitteln läßt, bei der eine oder mehrere Abbildungseigenschaften des Projektionsobjektivs 20 verbessert sind. Die weitere Belichtung lichtempfindlicher Oberflächen 26 erfolgt dann bei dieser zuletzt eingestellten Temperatur der Immersionsflüssigkeit 38.

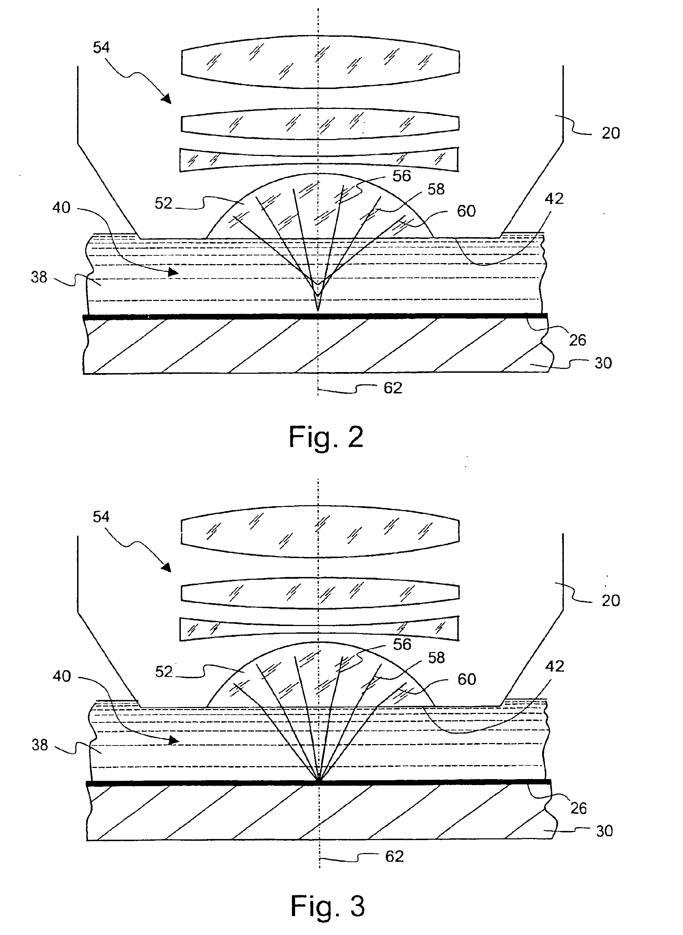

Der Einfluss des Brechungsindex der Immersionsflüssigkeit 38 auf die Abbildungseigenschaften des Projektionsobjektivs 20 wird im folgenden anhand der Figuren 2 bis 5 näher erläutert.

Figur 2 zeigt einen vergrößerten Ausschnitt aus Figur 1, in dem im Bereich des Zwischenraums 40 zwischen der Endfläche 42 des Projektionsobjektivs 20 und der lichtempfindlichen Oberfläche 26 ein Strahlengang angedeutet ist. Bei diesem Ausführungsbeispiel ist in die Endfläche 42 des Projektionsobjektivs 20 eine plan-konvexe Abschlußlinse 52 bündig abschließend eingelassen, die die letzte optische Komponente der mit 54 lediglich angedeuteten Projektionsoptik des Projektionsöbjektivs 20 darstellt. In Figur 2 sind zu Illustrationszwecken mehrere Projektionslichtstrahlen 56, 58, 60 eingezeichnet, die von den vorgelagerten optischen Komponenten der Projektionsoptik 54 auf die Abschlußlinse 52 geworfen werden. Die Darstellung ist stark schematisiert und nicht maßstäblich, um den Einfluß der Temperatur auf die Abbildungseigenschaften des Projektionsobjektivs 20 besser erläutern zu können.

Das in Figur 2 gezeigte Projektionsobjektiv 20 erzeugt eine durch sphärische Aberration verfälschte Abbildung. Dies bedeutet, daß sich die Brennweiten der achsennahen Projektionslichtstrahlen 56 und der achsenferneren Projektionslichtbündel 58 und 60 jeweils voneinander unterscheiden. In Figur 2 liegt nur die Brennebene der achsennahen Projektionslichtstrahlen 56 in der Ebene der lichtempfindlichen Oberfläche 26, während die Brennebenen der achsenferneren Projektionslichtstrahlen 58 und 60 in dem Zwischenraum 40 liegen. Der Abstand der Brennebenen von der lichtempfindlichen Oberfläche 26 nimmt dabei zu, je weiter entfernt von der mit 62 bezeichneten optischen Achse die Abschlußlinse 52 von den Projektionslichtstrahlen 56, 58, 60 durchtreten wird.

Figur 3 zeigt den Ausschnitt aus Figur 2, nachdem die Temperatur der Immersionsflüssigkeit 38 erhöht wurde. Die Immersionsflüssigkeit 38 weist nun einen höheren Brechungsindex auf als in dem in Figur 2 gezeigten Zustand. Dies führt dazu, daß an der Grenzfläche zwischen der Abschlußlinse 52 und der Immersionsflüssigkeit 38 die Projektionslichtstrahlen 56, 58, 60 stärker gebrochen werden. Diese stärkere Brechung wirkt sich umso mehr aus, je weiter die Projektionslichtstrahlen von der optischen Achse 62 entfernt sind, da die achsenferneren Projektionslichtstrahlen diese Grenzfläche unter einem größeren Winkel durchtreten. Dies führt dazu, daß sich die Brennweite des Projektionsobjektivs 20 für die achsenferneren Strahlen verlängert, so daß im Idealfall bei entsprechend gewählter Temperatur die Brennebenen aller Projektionslichtstrahlen 56, 58, 60 mit der Ebene zusammenfallen, in der die lichtempfindliche Oberfläche 26 angeordnet ist.

Durch Veränderung der Temperatur der Immersionsflüssigkeit 38 ist es somit möglich, eine dem Projektionsobjektiv 20 immanente sphärische Abberation nachträglich zu kompensieren.

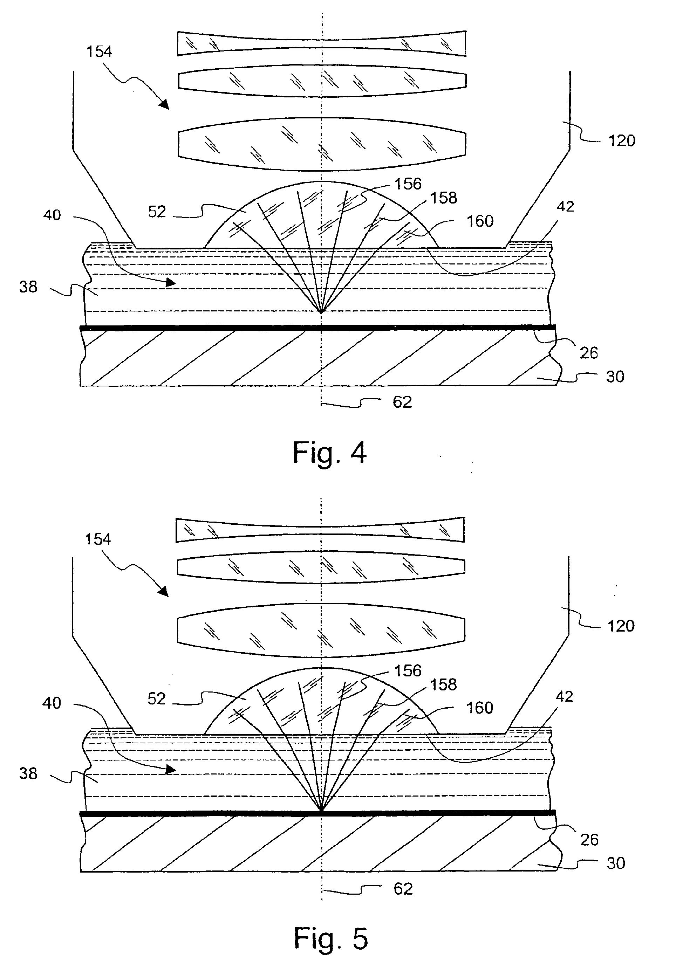

Figur 4 zeigt einen der Figur 2 entsprechenden vergrößerten Ausschnitt einer Projektionsbelichtungsanlage mit einem anderen Projektionsobjektiv 120. Dabei sind gegenüber Figur 2 veränderte Teile mit um 100 erhöhte Bezugsziffern bezeichnet. Die Projektionsoptik 154 des Projektionsobjektivs 120 weist, anders als die in den Figuren 2 und 3 gezeigte Projektionsoptik 54, keine immanente sphärische Aberration auf. Die Projektionslichtstrahlen 156, 158, 160 treffen sich daher in einem Brennpunkt. Wie in Figur 4 zu erkennen ist, liegt dieser Brennpunkt jedoch nicht in der Ebene der lichtempfindlichen Oberfläche 26, d. h. das Projektionsobjektiv 120 weist einen Fokusfehler auf. Ein solcher Fokusfehler könnte beispielsweise behoben werden, indem der Träger 30 mit der lichtempfindlichen Oberfläche 26 geringfügig mit Hilfe einer geeigneten Verfahreinrichtung in Richtung der optischen Achse 62 verfahren wird. Die hierfür erforderliche Genauigkeit ist allerdings mit Hilfe mechanischer Verfahreinrichtungen nur mit großem technischen Aufwand realisierbar.

Wie Figur 5 zeigt, kann durch eine Erhöhung der Temperatur der Immersionsflüssigkeit 38 ebenfalls eine Vergrößerung der Brennweite des Projektionsobjektivs 120 erzielt werden. Zwar wird dadurch eine sphärische Aberration eingeführt, die in Figur 5 nicht dargestellt ist. Die Auswirkungen einer solchen sphärischen Aberration können aber so gering sein, daß sie angesichts der Optimierung der Brennweite des Projektionsobjektivs vernachlässigbar oder aber durch andere Maßnahmen kompensierbar sind.

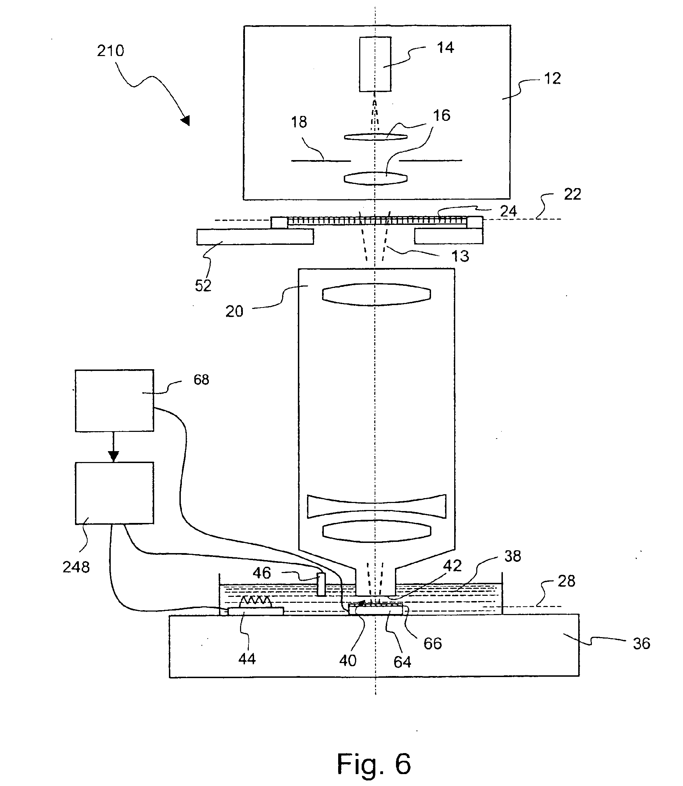

Figur 6 zeigt ausschnittsweise ein weiteres Ausführungsbeispiel einer insgesamt mit 210 bezeichneten Projektionsbelichtungsanlage in einer an die Figur 1 angelehnten Darstellung. Auch hier sind gegenüber Figur 1 veränderte Teile mit um 200 erhöhten Bezugsziffern versehen.

Figur 6 zeigt die Projektionsbelichtungsanlage 210 in einem Einstellmodus, bei dem der Träger 30 gegen eine Sensoreinrichtung 64 ausgetauscht ist. Bei der Sensoreinrichtung 64 kann es sich beispielsweise um einen an sich bekannten CCD-Sensor handeln. In dem Einstellmodus ist eine lichtempfindliche Oberfläche 66 der Sensoreinrichtung 64 in der Bildebene 28 des Projektionsobjektivs 20 angeordnet. Auf diese Weise wird von der Sensoreinrichtung 64 genau dasjenige Bild erfasst, dem während des normalen Projektionsmodus die zu belichtende lichtempfindliche Oberfläche 26 ausgesetzt ist. Die Projektion erfolgt dabei mit einem besonderen Testretikel 70, das anstelle des normalen Retikels 24 in der Objektebene 22 des Projektionsobjektivs 20 angeordnet ist.

Anstelle des CCD-Sensors kann auch in an sich bekannter Weise ein Interferometer als Sensoreinrichtung eingesetzt werden. Damit lassen sich Wellenfronten in Pupillenebenen erfassen. Im einzelnen ist dies in der oben bereits erwähnten WO 01/63233 A1 erläutert.

Im Unterschied zur Projektionsbelichtungsanlage 10 aus Figur 1 weist die Projektionsbelichtungsanlage 210 zusätzlich eine Recheneinheit 68 auf, die mit einem Temperaturregler 248 für die Temperiereinrichtung 44 verbunden ist. Im Einstellmodus funktioniert die Projektionsbelichtungsanlage 210 wie folgt:
Zunächst werden die auf dem Testretikel 70 enthaltenen Strukturen von dem Projektionsobjektiv 20 auf der lichtempfindlichen Oberfläche 66 der Sensoreinrichtung 64 abgebildet. Dieses Abbild wird von der Sensoreinrichtung 64 erfasst und in digitaler Form der Recheneinheit 68 übermittelt. Diese bestimmt aus den erhaltenen Daten eine Führungstemperatur, die an den Temperaturregler 248 weitergegeben wird. Der Temperaturregle 248 stellt nun sicher, daß die Immersionsflüssigkeit 38 auf diese neue Führungstemperatur gebracht wird. Die Sensoreinrichtung 64 erfasst das durch die Temperaturänderung veränderte Abbild der Strukturen des Testretikels 70 und führt auch diese Daten der Recheneinheit 68 zu. Mit Hilfe an sich bekannter Algorithmen stellt die Recheneinheit 68 fest, ob sich durch die Temperaturänderung eine Verbesserung oder Verschlechterung der Abbildungseigenschaften des Projektionsobjektivs 120 ergeben haben. In Abhängigkeit von diesem Ergebnis wird die Führungstemperatur erneut verändert. Dieser rekursive Vorgang wird so lange fortgesetzt, bis sich keine Verbesserung der Abbildungseigenschaften des Projektionsobjektivs durch eine Temperaturveränderung mehr erzielen läßt.

## Patentansprüche

1. Verfahren zur Verbesserung einer optischen Abbildungseigenschaft eines Projektionsobjektivs (20; 120) das Teil einer mikrolithografischen Projektionsbelichtungsanlage (10; 210) ist, mit der sich ein in einer Objektebene (22) des Projektionsobjektivs (20; 120) angeordnetes Retikel (24) durch das Projektionsobjektiv (20; 120) hindurch auf eine in einer Bildebene (28) des Projektionsobjektivs angeordnete lichtempfindliche Oberfläche (26; 66) abbilden läßt, wobei eine Immersionsflüssigkeit (38) in einen Zwischenraum (40) zwischen der lichtempfindlichen Oberfläche (26; 66) und einer dieser Oberfläche (26; 66) zugewandten Endfläche (42) des Projektionsobjektivs (20; 120) eingebracht wird,
**gekennzeichnet durch** folgende weitere Schritte:
a) Ermitteln einer Abbildungseigenschaft des Projektionsobjektivs (20; 120) ;
b) Vergleichen der ermittelten Abbildungseigenschaft mit einer Soll-Abbildungseigenschaft;
c) Verändern der Temperatur der Immersionsflüssigkeit (38) so lange, bis die ermittelte Abbildungseigenschaft der Soll-Abbildungseigenschaft möglichst nahe kommt.

2. Verfahren nach Anspruch 1, **dadurch gekennzeichnet,**
**daß** die Abbildungseigenschaft ermittelt wird, indem ein Testretikel (70) durch das Projektionsobjektiv (20) und die Immersionsflüssigkeit (38) hindurch auf ein in der Bildebene (28) angeordnetes lichtempfindliches Element (64) abgebildet wird.

3. Verfahren nach Anspruch 2, **dadurch gekennzeichnet,**
**daß** das lichtempfindliche Element eine Sensoreinrichtung (64), insbesondere ein CCD-Sensor, ist.

4. Verfahren nach Anspruch 1, **dadurch gekennzeichnet,**
**daß** die Abbildungseigenschaft unter Verwendung eines Interferometers ermittelt wird.

5. Verfahren nach einem der vorhergehenden Ansprüche,
**dadurch gekennzeichnet, daß** die optische Abbildungseigenschaft die Größe einer durch das Projektionsobjektiv (20) verursachten sphärischen Aberration ist.

6. Verfahren nach einem der Ansprüche 1 bis 4, **dadurch**
**gekennzeichnet, daß** die optische Abbildungseigenschaft die Brennweite des Projektionsobjektivs (120) ist.

7. Mikrolithografische Projektionsbelichtungsanlage zur
Abbildung eines in einer Objektebene (22) eines Projektionsobjektivs (20) angeordneten Retikels (24) durch das Projektionsobjektiv (20) hindurch auf eine in einer Bildebene (28) des Projektionsobjektivs (20) angeordnete lichtempfindliche Oberfläche (26), mit Mitteln (32) zum Einbringen einer Immersionsflüssigkeit (38) in einen Zwischenraum (40) zwischen der lichtempfindlichen Oberfläche (26) und einer dieser Oberfläche (26) zugewandten Endfläche (42) des Projektionsobjektivs (20), und mit einer Temperaturregelungseinrichtung (248) zur Einstellung einer Soll-Temperatur der Immersionsflüssigkeit (38),
**gekennzeichnet durch**
eine in der Bildebene (28) anordenbare Sensoreinrichtung (64) zur Erfassung einer Abbildungseigenschaft des Projektionsobjektivs (20) und einer mit der Sensoreinrichtung (64) und der Temperaturregelungseinrichtung (248) verbundenen Recheneinheit (68), mit der aus von der Sensoreinrichtung (64) erzeugten Signalen die Soll-Temperatur der Immersionsflüssigkeit (238) so bestimmbar ist, daß sich die Abbildungseigenschaft des Projektionsobjektivs (20) bei Einstellen der Soll-Temperatur verbessert.

8. Mikrolithografische Projektionsbelichtungsanlage
zur Abbildung eines in einer Objektebene (22) angeordneten Retikels (24) durch ein Projektionsobjektiv (20; 120) hindurch auf eine in einer Bildebene (28) angeordnete lichtempfindliche Oberfläche (26), mit einer in einen Zwischenraum (40) zwischen der lichtempfindlichen Oberfläche (26; 126) und einer dieser Oberfläche (26) zugewandten Endfläche (42) des Projektionsobjektivs (20; 120) eingebrachten Immersionsflüssigkeit (38),
**dadurch gekennzeichnet,**
**daß** die Temperatur der Immersionsflüssigkeit (38) so gewählt ist, daß durch die Immersionsflüssigkeit (38) eine dem Projektionsobjektiv (20; 120) eigene sphärische Aberration kompensiert ist.

## Claims

1. Method for improving an optical imaging property of a projection objective (20; 120) which is part of a microlithographic projection exposure apparatus (10; 210) which can image a reticle (24), arranged in an object plane (22) of the projection objective (20; 120), through the projection objective (20; 120) onto a photosensitive surface (26; 66) arranged in an image plane (28) of the projection objective, wherein an immersion liquid (38) is introduced into an intermediate space (40) between the photosensitive surface (26; 66) and an end face (42) of the projection objective (20; 120), which end face faces this surface (26; 66),
**characterised by** the following further steps:
a) determining an imaging property of the projection objective (20; 120);
b) comparing the imaging property as determined with a target imaging property;
c) changing the temperature of the immersion liquid (38) until the imaging property as determined is as close as possible to the target imaging property.

2. Method according to claim 1, **characterised in that** the imaging property is determined by imaging a test reticle (70) through the projection objective (20) and the immersion liquid (38) onto a photosensitive element (64) arranged in the image plane (28).

3. Method according to claim 2, **characterised in that** the photosensitive element is a sensor device (64), in particular a CCD sensor.

4. Method according to claim 1, **characterised in that** the imaging property is determined by using an interferometer.

5. Method according to any of the preceding claims, **characterised in that** the optical imaging property is the extent of a spherical aberration caused by the projection objective (20).

6. Method according to one of claims 1 to 4, **characterised in that** the optical imaging property is the focal length of the projection objective (120).

7. Microlithographic projection exposure apparatus for imaging a reticle (24), arranged in an object plane (22) of a projection objective (20), through the projection objective (20) onto a photosensitive surface (26) arranged in an image plane (28) of the projection objective (20), comprising means (32) for introducing an immersion liquid (38) into an intermediate space (40) between the photosensitive surface (26) and an end face (42) of the projection objective (20), which end face faces this surface (26), and a temperature control device (248) for setting a target temperature of the immersion liquid (38),
**characterised by**
a sensor device (64) which can be arranged in the image plane (28) for measuring an imaging property of the projection objective (20) and a computer unit (68), which is connected to the sensor device (64) and the temperature control device (248) and which can be used to determine the target temperature of the immersion liquid (238) such that the imaging property of the projection objective (20) improves if the target temperature is set.

8. Microlithographic projection exposure apparatus for imaging a reticle (24) arranged in an object plane (22) through a projection objective (20; 120) onto a photosensitive surface (26) arranged in an image plane (28), comprising an immersion liquid (38) introduced into an intermediate space (40) between the photosensitive surface (26; 126) and an end face (42) of the projection objective (20; 120), which end face faces this surface (26),
**characterised in that**
the temperature of the immersion liquid (38) is selected such that the immersion liquid (38) compensates for a spherical aberration associated with the projection objective (20; 120).

## Revendications

1. Procédé pour améliorer une propriété de reproduction optique d'un objectif de projection (20 ; 120) qui fait partie d'une installation d'exposition par projection microlithographique (10 ; 210) avec laquelle un réticule (24) disposé dans un plan objet (22) de l'objectif de projection (20 ; 120) peut être reproduit à travers l'objectif de projection (20 ; 120) sur une surface photosensible (26 ; 66) disposée dans un plan image (28) de l'objectif de projection, un liquide d'immersion (38) étant introduit dans un interstice (40) entre la surface photosensible (26 ; 66) et une surface d'extrémité (42) de l'objectif de projection (20 ; 120) tournée vers cette surface (26 ; 66),
**caractérisé par** les étapes supplémentaires suivantes :
a) détermination d'une propriété de reproduction de l'objectif de projection (20 ; 120) ;
b) comparaison de la propriété de reproduction déterminée avec une propriété de reproduction de consigne ;
c) modification de la température du liquide d'immersion (38) jusqu'à ce que la propriété de reproduction déterminée se rapproche le plus possible de la propriété de reproduction de consigne.

2. Procédé selon la revendication 1, **caractérisé en ce que** la propriété de reproduction est déterminée en reproduisant un réticule de test (70) à travers l'objectif de projection (20) et le liquide d'immersion (38) sur un élément photosensible (64) disposé dans le plan image (28).

3. Procédé selon la revendication 2, **caractérisé en ce que** l'élément photosensible est un dispositif capteur (64), en particulier un capteur à couplage de charge ou CCD.

4. Procédé selon la revendication 1, **caractérisé en ce que** la propriété de reproduction est déterminée en utilisant un interféromètre.

5. Procédé selon l'une des revendications précédentes, **caractérisé en ce que** la propriété de reproduction optique est la grandeur d'une aberration sphérique causée par l'objectif de projection (20).

6. Procédé selon l'une des revendications 1 à 4, **caractérisé en ce que** la propriété de reproduction optique est la distance focale de l'objectif de projection (120).

7. Installation d'exposition par projection microlithographique servant à reproduire un réticule (24) disposé dans un plan objet (22) d'un objectif de projection (20) à travers l'objectif de projection (20) sur une surface photosensible (26) disposée dans un plan image (28) de l'objectif de projection (20), comprenant des moyens (32) pour introduire un liquide d'immersion (38) dans un interstice (40) entre la surface photosensible (26) et une surface d'extrémité (42) de l'objectif de projection (20) tournée vers cette surface (26) et comprenant un dispositif de réglage de la température (248) pour régler une température de consigne du liquide d'immersion (38),
**caractérisée par**
un dispositif capteur (64) pouvant être disposé dans le plan image (28) pour saisir une propriété de reproduction de l'objectif de projection (20) et une unité de calcul (68) reliée au dispositif capteur (64) et au dispositif de réglage de la température (248), avec laquelle la température de consigne du liquide d'immersion (238) peut être déterminée à partir des signaux générés par le dispositif capteur (64) de façon que la propriété de reproduction de l'objectif de projection (20) s'améliore en cas de réglage de la température de consigne.

8. Installation d'exposition par projection microlithographique servant à reproduire un réticule (24) disposé dans un plan objet (22) à travers un objectif de projection (20 ; 120) sur une surface photosensible (26) disposée dans un plan image (28), comprenant un liquide d'immersion (38) introduit dans un interstice (40) entre la surface photosensible (26 ; 126) et une surface d'extrémité (42) de l'objectif de projection (20 ; 120) tournée vers cette surface (26),
**caractérisée en ce**
**que** la température du liquide d'immersion (38) est choisie de façon qu'une aberration sphérique propre à l'objectif de projection (20 ; 120) soit compensée par le liquide d'immersion (38).
